# EUROPÄISCHE PATENTSCHRIFT

(11) **EP 3 468 320 B1**
(45) Veröffentlichungstag und Bekanntmachung des Hinweises auf die Patenterteilung: **04.12.2024**
(21) Anmeldenummer: 18199270.2
(22) Anmeldetag: 09.10.2018
(51) Int. Cl.: H05K 5/00

(54) **ELEKTRISCHE BAUEINHEIT IN GEHÄUSE AUS UNTERSCHIEDLICHEN MATERIALIEN**
ELECTRICAL COMPONENT IN HOUSING MADE OF DIFFERENT MATERIALS
MODULE ÉLECTRIQUE DANS LE BOÎTIER DE DIFFÉRENTS MATÉRIAUX

(30) Priorität: 09.10.2017 DE 102017123354
(43) Veröffentlichungstag der Anmeldung: 10.04.2019
(73) Patentinhaber: Zollner Elektronik AG, 93499 Zandt (DE)
(72) Erfinder: Bruckner, Gerhard, 94234 Viechtach (DE)
(74) Vertreter: Hannke Bittner & Partner mbB Regensburg

(56) Entgegenhaltungen:
- EP-A1- 0 777 407
- EP-A1- 2 634 457
- WO-A1-2017/124306
- DE-A1- 10 346 990
- DE-A1- 102012 223 354
- DE-A1- 102015 225 219
- DE-A1- 19 924 344
- DE-A1- 19 933 566
- DE-A1- 3 918 651
- DE-A1- 4 106 077
- DE-T5- 112015 000 805
- DE-U1- 9 213 671

## Beschreibung

Die vorliegende Erfindung bezieht sich auf eine elektrische Baueinheit für Kraftfahrzeuge.

Die Erfindung wird unter Bezugnahme auf einen Bestandteil eines Ladesystems bzw. eines elektrischen Ladesystems für Kraftfahrzeuge beschrieben. Insbesondere enthält diese elektrische Baueinheit zumindest eine Spule, die zur Übertragung von elektrischer Energie auf induktivem Wege geeignet und bestimmt ist. Es wird jedoch darauf hingewiesen, dass die vorliegende Erfindung auch auf andere elektrische Baueinheiten angewandt werden kann, insbesondere elektrische Baueinheiten, die im Betrieb schwierigen Umgebungsbedingungen unterworfen sind, wie etwa Vibrationen, starken Temperaturschwankungen und dergleichen. Aus dem Stand der Technik sind unterschiedliche Baueinheiten, die in Gehäusen untergebracht sind, bekannt. Bei Baueinheiten, die an Außenseiten, beispielsweise an Unterseiten von Kraftfahrzeugen, anzubringen sind, sind jedoch zusätzlich etliche Kriterien zu beachten. So muss die Anfälligkeit derartiger Baueinheiten gegenüber Vibrationen vermindert werden sowie auch die Anfälligkeit gegenüber Spritzwasser und Schmutz. Daneben müssen derartige Baueinheiten auch hohe Temperaturen und auch starke Temperaturschwankungen bewältigen können.

DE 10 2012 223354 A1 zeigt eine elektrische Baueinheit mit den Merkmalen des Oberbegriffs des Anspruchs 1.

Der vorliegenden Erfindung liegt daher die Aufgabe zugrunde, eine elektrische Baueinheit zur Verfügung zu stellen, welche insbesondere diesen oben genannten Kriterien genügt. Eine erfindungsgemäße elektrische Baueinheit für Kraftfahrzeuge ist im Anspruch 1 definiert und weist ein Gehäuse auf, innerhalb dessen wenigstens ein elektrisches Bauelement angeordnet ist. Weiterhin weist die Baueinheit eine Schnittstelle auf, welche bevorzugt wenigstens teilweise außerhalb des Gehäuses liegt und welche eine elektrisch leitende Kontaktierung bzw. Verbindung dieses Bauelements ermöglicht. Dabei weist das Gehäuse einen ersten Gehäuseteil und einen zweiten Gehäuseteil auf, welche mit wenigstens einem Befestigungsmittel aneinander befestigt sind. Dabei erstrecken sich diese Gehäuseteile zumindest entlang einer Längsrichtung und entlang einer zu dieser Längsrichtung senkrechten Breitenrichtung.

Erfindungsgemäß sind der erste Gehäuseteil und der zweite Gehäuseteil aus unterschiedlichen Materialien gefertigt. Durch die Anfertigung in unterschiedlichen Materialien können auch unterschiedlichste Ausdehnungen der beiden Materialien kompensiert werden. Dabei kann eines der beiden Materialien dazu geeignet sein, dass durch diesen jeweiligen Gehäuseteil hindurch eine Induktion beispielsweise mit anderen Bauelementen möglich ist. Insbesondere kann ein Gehäuseteil dazu geeignet und bestimmt sein, einen magnetischen Fluss nicht zu behindern.

Unter einem elektrischen Bauelement wird ein Bauelement verstanden, welches insbesondere durch elektrische Energie betrieben wird und/oder welches zum Leiten elektrischer Ströme und/oder elektrischer und/oder magnetischer Felder geeignet ist. Dabei kann es sich sowohl um aktive elektrische Bauelemente, wie beispielsweise Halbleiterelemente handeln wie auch um passive elektrische Bauelemente, wie Widerstände, Spulen, Ferritkörper und dergleichen.

Bevorzugt kann auch eines der beiden Materialien derart ausgebildet sein, dass es einen guten Temperaturfluss erlaubt, sodass eine Wärmeabführung und/oder damit eine Kühlung des Bauelements möglich ist.

Bevorzugt kann es sich bei dem Befestigungsmittel, um die Baueinheit an dem Kraftfahrzeug und insbesondere an einem Rahmenbereich des Kraftfahrzeugs anzuordnen, um ein oder mehrere Schraubmittel handeln. Diese Schraubmittel können dabei bevorzugt an einem der beiden Gehäuseteile angeordnet sein. Bevorzugt erstrecken sich diese Befestigungsmittel und oder Schraubmittel durch den jeweils anderen Gehäuseteil bzw. einen Bereich desselben hindurch.

Bei einer bevorzugten Ausführungsform erstreckt sich das Gehäuse bzw. die beiden Gehäuseteile wesentlich weiter bzw. länger in der Längsrichtung und der Breitenrichtung, als in einer hierzu senkrecht stehenden Höhenrichtung. Damit ist bevorzugt das Gehäuse als relativ flaches insbesondere annähernd quaderförmiges Gehäuse ausgeführt. Vorteilhaft weisen die Gehäuseteile und/oder weist das so zusammengesetzte Gehäuse abgerundete Ecken auf. Bei einer weiteren bevorzugten Ausführungsform sind die Oberflächen des Gehäuses vorteilhaft glatt ausgeführt. Auf diese Weise kann ein Windwiderstand des Gehäuses gering gehalten werden.

Mit anderen Worten wird die Oberfläche an wenigstens einem Gehäuseteil, beispielsweise an einem Aluminiumgehäuseteil, und auch an dem anderen Gehäuseteil, wie etwa einem Kunststoffgehäuseteil, um Fahrgeräusche zu vermindern, glatt ausgeführt. Etwaige Öffnungen, die hier beispielsweise für eine Verschraubung und/oder Verbindung vorhanden oder erforderlich sind, werden bevorzugt verschlossen. Sämtliche Kanten sind bevorzugt wie oben erwähnt verrundet.

Bei einer weiteren vorteilhaften Ausführungsform ist wenigstens ein Gehäuseteil aus einem Kunststoff gefertigt. Bei einer weiteren vorteilhaften Ausführungsform ist wenigstens ein Gehäuseteil aus einem Metall gefertigt. Bevorzugt ist derjenige Gehäuseteil, der aus dem Kunststoff gefertigt ist, derjenige Gehäuseteil, dem in einem Ladezustand eine weitere Spule, etwa eine fest installierte oder stationäre Ladespule, gegenüberliegt. Dies bedeutet, dass der Ladevorgang durch das Kunststoffgehäuse bzw. den Kunststoffgehäuseteil hindurch erfolgt. Bei dem Metall handelt es sich bevorzugt um Aluminium.

Bei einer weiteren vorteilhaften Ausführungsform ist die Schnittstelle an genau einem Gehäuseteil angeordnet und insbesondere an dem Gehäuseteil aus Metall angeordnet. Bei einer bevorzugten Ausführungsform ist die Schnittstelle, beispielsweise ein Steckelement, derart gestaltet, dass Steckeranbindungen direkt in ein Aluminiumgehäuseteil integriert werden können. Dies kann durch eine entsprechende Gestaltung des Aluminiumgehäuseteils erfolgen.

Auf diese Weise kann beispielsweise auf einen zusätzlichen Flansch verzichtet werden.

Bei einer weiteren bevorzugten Ausführungsform ist in wenigstens einem Gehäuseteil und insbesondere in dem Gehäuseteil, welches aus einem Kunststoff besteht, die Spuleneinrichtung angeordnet. Bevorzugt weist daher dieser Gehäuseteil einen Aufnahmebereich zur Aufnahme der Spuleneinrichtung auf. Dabei ist dieser Aufnahmebereich bevorzugt derart gestaltet, dass die gesamte Spuleneinrichtung in diesem Gehäuseteil untergebracht werden kann.

Bevorzugt ist dabei die Spuleneinrichtung gegenüber dem ersten Gehäuseteil fixiert. Bevorzugt ist die Spuleneinrichtung ausschließlich gegenüber dem ersten Gehäuseteil fixiert und steht besonders bevorzugt nicht mit dem zweiten Gehäuseteil in Kontakt.

Bei einer bevorzugten Ausführungsform dient auch wenigstens ein Gehäuseteil und bevorzugt der aus dem Kunststoff gefertigte Gehäuseteil zur Aufnahme eines Ferritkörpers. Besonders bevorzugt sind Halteeinrichtungen vorgesehen, welche den Ferritkörper gegenüber diesem Gehäuseteil fixieren und insbesondere auch ausschließlich gegenüber diesem Gehäuseteil fixieren. Bevorzugt kontaktiert auch der Ferritkörper nicht diesen Gehäuseteil. Auch hier ist bevorzugt durch eine entsprechende konstruktive Ausgestaltung des Gehäuseteils eine definierte Lage des Ferritkörpers gegenüber diesem Gehäuseteil erreicht.

Bei einer weiteren vorteilhaften Ausführungsform ist an wenigstens einem Gehäuseteil ein Befestigungsmittel angeordnet, um die elektrische Baueinheit an dem Kraftfahrzeug zu befestigen. Insbesondere sind die Befestigungsmittel dafür vorgesehen, um das Gehäuseteil und insbesondere die gesamte Baueinheit an einer Außenseite des Kraftfahrzeugs, beispielsweise an einem Rahmenelement zu befestigen. Insbesondere kann die Baueinheit an einer Unterseite des Fahrzeugs befestigt werden.

Bei einer bevorzugten Ausführungsform sind mehrere Befestigungsmittel an dem jeweils wenigstens einen Gehäuseteil angeordnet. Bevorzugt sind diese Befestigungsmittel stift- oder schraubenartig ausgeführt und erstrecken sich bevorzugt in einer Dickenrichtung der Baueinheit bzw. senkrecht zu der Längs- und senkrecht zu der Breitenrichtung. Dabei können diese Befestigungsmittel bzw. Vorsprünge derart ausgebildet sein, dass sie sich durch Öffnungen bzw. Löcher des jeweils anderen Gehäuseteils hindurch erstrecken. So kann eine Vielzahl von insgesamt umlaufenden Befestigungsmitteln vorgesehen sein, mittels denen die Baueinheit an dem Kraftfahrzeug befestigt wird.

Bei einer bevorzugten Ausführungsform ist das wenigstens eine Befestigungsmittel und sind bevorzugt diese mehreren Befestigungsmittel randseitig an dem Gehäuse angeordnet. Besonders bevorzugt sind diese Befestigungsmittel entlang eines Außenumfangs des Gehäuses angeordnet. Bevorzugt ist das wenigstens eine Befestigungsmittel drehbar und insbesondere drehbar bezüglich einer Längsrichtung des Befestigungsmittels gegenüber wenigstens einem Gehäuseteil und bevorzugt gegenüber beiden Gehäuseteilen angeordnet.

Bei einer bevorzugten Ausführungsform weist wenigstens eines dieser Befestigungsmittel ein Außengewinde auf. Bei einer weiteren bevorzugten Ausführungsform weist die Vorrichtung wenigstens zwei derartige Befestigungsmittel auf, bevorzugt wenigstens vier derartige Befestigungsmittel.

Bevorzugt dient wenigstens ein Gehäuseteil zum Abführen von Abwärme und damit mittelbar zum Kühlen der jeweiligen elektrischen Bauteile. So kann beispielsweise eine Entwärmung des gesamten Systems mittels einer passiven Kühlung erfolgen. Alternativ wäre jedoch auch eine Entwärmung des Systems mit einer aktiven Kühlung möglich, beispielsweise durch Integration eines Kühlkreises. Das Metallgehäuseteil bzw. Aluminiumgehäuseteil kann sowohl mit der Funktion als passive Kühlung als auch mit der Funktion als aktive Kühlung ausgestattet bzw. umgesetzt sein.

Bei einer bevorzugten Ausführungsform ist der metallische Gehäuseteil, beispielsweise der Aluminiumgehäuseteil, schwarz ausgeführt, beispielsweise schwarz eloxiert. Bei einer bevorzugten Ausführungsform ist insbesondere im Inneren des Gehäuses ein wärmeleitendes Material vorgesehen, insbesondere eine Wärmeleitpaste und besonders bevorzugt eine dauerelastische Wärmeleitpaste. Diese kann Wärme von den elektrischen Bauteilen auf das metallische Gehäuseteil übertragen. Auf diese Weise ist eine verbesserte passive Kühlung der Baueinheit möglich.

Bei einer weiteren vorteilhaften Ausführungsform ist zwischen dem ersten Gehäuseteil und dem zweiten Gehäuseteil wenigstens eine Dichtungseinrichtung angeordnet. Diese Dichtungseinrichtung kann dabei beispielsweise als umlaufende Dichtung vorgesehen sein, beispielsweise eine Silikondichtung. Hierbei ist zu beachten, dass eine Montageposition oder eine Verbausituation an einer exponierten Stelle im Fahrzeug erfolgt.

So kann beispielsweise die Baueinheit an das sogenannte Schubfeld angeschraubt sein, beispielsweise an die unterste Ebene in einem Fahrzeug in Richtung der Straße. Hierbei besteht insbesondere die Gefahr einer Belastung der Baugruppe durch Salzwasser und/oder Regenwasser. So könnte beispielsweise ein Fluid in das Gehäuse eindringen mit der Folge eines Kurzschlusses oder einer Beschädigung von elektronischen Bauteilen. Durch die hier beschriebene ausgeführte Konstruktion ergibt sich für das CPM-Modul (Car Pad Module) bevorzugt nur eine einzige Dichtungsebene nach außen und insbesondere eine umlaufende Dichtungsebene.

Bevorzugt weist also die Baueinheit lediglich eine Dichtungsebene auf, durch welche jedoch wie oben erwähnt keine Flüssigkeit treten kann. Bevorzugt ist das Gehäuse der Baueinheit vollumfänglich abgeschlossen. Durch das Vorhandensein nur einer einzigen Dichtungsebene erhöht sich die Prozesssicherheit des Produkts bezüglich seiner Herstellung und es verringert sich bevorzugt auch die Gefahr eines Funktionsausfalls im Feld oder im Betrieb. Daneben führt eine einzige Dichtungsebene auch zu einer kostengünstigeren Fertigung des CPM-Moduls. Wie oben erwähnt, kann es sich bei der Dichtungseinrichtung beispielsweise um eine applizierte Dichtungseinrichtung handeln. Daneben wäre es auch möglich, dass die Dichtungseinrichtung eine Verklebung ist, beispielsweise eine Verklebung der beiden Gehäusehälften bzw. Gehäuseteile. Bevorzugt wird daher zum Zweck der Abdichtung eine Applikation und/oder eine Verklebung angewandt.

Erfindungsgemäß ist zwischen diesen beiden Gehäuseteilen ein umlaufender Spalt ausgebildet, innerhalb dessen besonders bevorzugt wenigstens ein Dichtmittel angeordnet ist. Dabei erstreckt sich dieser Spalt in Richtung des Inneren des Gehäuses labyrinthartig bzw. dieser Spalt wechselt wenigstens zweimal seine Richtung. Dabei können diese Richtungen senkrecht zueinander stehen.

Bevorzugt weist das Gehäuse wenigstens abschnittsweise eine sogenannte Tropfkante auf. Eine derartige Tropfkante bietet einen zusätzlichen Schutz für die Dichtung, insbesondere wenn das CPM-Modul beispielsweise gereinigt wird, beispielsweise mit einem Dampfstrahler gereinigt wird. Bevorzugt ist diese Tropfkante umlaufend um das Gehäuse ausgebildet. Bevorzugt handelt es sich bei dieser Tropfkante um eine insbesondere an dem zweiten und/oder unteren Gehäuseteil ausgebildete Kante, welche insbesondere vorkragend ausgebildet ist. Auf diese Weise kann etwa vorhandene Flüssigkeit günstig abgeleitet werden. Auf diese Weise ist ein verbesserter Schutz gegenüber Spritzwasser möglich.

Das wenigstens ein elektrisches Bauelement ist eine Spule. Damit handelt es sich bevorzugt bei der Baueinheit um eine Spulenanordnung, welche insbesondere für elektrische Ladesysteme dient und welche beispielsweise von einer weiteren Ladespule mit elektrischer Energie versorgt werden kann.

Bevorzugt ist die Spuleneinrichtung und insbesondere eine Litze der Spuleneinrichtung vibrationsfest mit einer Platine verbunden. Dabei kann beispielsweise die Verbindung der Litze mit der Platine mit einer entsprechenden Gestaltung eines Drehteils verbunden sein. Dieses Drehteil ist bevorzugt als SMC-Bauteil gestaltet und an diesem ist bevorzugt ein Kabelschuh angeordnet. Ein derartiger Kabelschuh kann dann mit dem Drehteil verschraubt sein. Daneben ist es auch möglich, dass ein Verbindungsmittel und/oder eine Befestigungseinrichtung wie Schraube zusätzlich gegen Verlust und damit zur Vermeidung einer Kurzschlussgefahr zusätzlich mit einer Verklebung gesichert ist. Die Verbindung eines Kabelschuhs mit der Litze bzw. der Spule kann beispielsweise über einen sogenannten Heißcrimpprozess erfolgen.

Bei einer bevorzugten Ausführungsform weist die Vorrichtung weiterhin ein Ferritelement bzw. einen Ferritkörper, beispielsweise einen sogenannten Ferritspiegel auf. Dabei kann die Spule an diesem Ferritkörper (insbesondere mit einem dazwischen angeordneten Isolationsmaterial) anliegen, sodass die Ferritkörper beispielsweise so angeordnet ist, dass die Spule an dem Ferritkörper anliegt und die Spule zwischen dem Kunststoffgehäuseteil und dem Ferritelement vorgesehen ist. Besonders bevorzugt kann dieser funktionelle Bereich, der die Litze und den Ferritkörper enthält, in einem fluiddichten Bereich kompaktiert werden und besonders bevorzugt mit Hilfe eines Vergussmaterials kompaktiert werden. Besonders bevorzugt handelt es sich bei dem Vergussmaterial um ein Epoxidharz.

Dabei kann dieses Vergussmaterial die Erhöhung der Festigkeit des CPM-Moduls bewirken. Ein Kraftfluss wird damit besser durch ein Kunststoffgehäuseteil bis hin zu einem zweiten Gehäuseteil, beispielsweise dem Aluminiumgehäuseteil durchgeleitet. Das Aluminiumgehäuseteil, welches bevorzugt zur Erhöhung der Biegefestigkeit verstrebt ist und besonders bevorzugt an seiner Unterseite verstrebt ist, nimmt aufgrund des wesentlich höheren E-Moduls die meiste Verformungsarbeit auf. Auf diese Weise kann auch eine Gewährleistung der Funktion des oder der Ferritelemente bei einem Bruch erfolgen. Daneben kann auch die Litze bzw. die Spule geschützt werden. Insbesondere kann auf diese Weise die Gefahr einer Kurzschlussbildung innerhalb der Litze verringert werden. Diese könnte beispielsweise durch einen Scheuervorgang durch Vibration entstehen.

Daneben wird der Ferritkörper bzw. werden Ferritelemente dieses Ferritkörpers vor Vibration geschützt. Bei einer bevorzugten Ausführungsform ist der Ferritkörper mit wenigstens einem Schutzelement versehen. Bevorzugt weist dieses Schutzelement einen Kunststoff auf und besteht bevorzugt aus einem Kunststoff. Bevorzugt ist dieses Kunststoffmaterial elastisch, um bei den auftretenden Verformungen des Gehäuses durch Kräfte von außen, die dabei entstehende Belastung und/oder Verformung der Ferrite zu reduzieren, um so die Ferrite vor Bruch oder Absplitterungen kleiner Partikel zu schützen.

Bei einer weiteren vorteilhaften Ausführungsform ist die Baueinheit direkt mit dem Rahmen eines Fahrzeugs und insbesondere direkt mit dem Schubfeld eines Fahrzeugs verschraubbar. Diese direkte Verschraubung hat den Vorteil, dass über das Wärmeleitpad, insbesondere den einen Gehäuseteil, günstiger Wärme abgeleitet werden kann. Dieses Wärmeleitpad bzw. das als Wärmeleitpad dienende Gehäuseteil ermöglicht in einem bestimmten Rahmen die Wärmeabfuhr an das Schubfeld eines Kraftfahrzeugs. Allerdings können aufgrund dieser direkten Verschraubung auch Baugruppen im Fahrzeug und auch der Fahrbetrieb ungewollte Vibrationen der Baueinheit verursachen. Dies kann auch zu einer Schädigung von Schnittstellen in der Baugruppe führen. Es wird daher vorgeschlagen, dass eine Dichtung, insbesondere eine Silikondichtung auf dem Aluminiumgehäuseteil angebracht wird. Vorteilhaft werden derartige Dichtungen an jeder Schraubstelle angebracht. Auch kann durch Anbringen derartiger Dichtungen an jeder Schraubstelle das Eindringen eines schädlichen Fluids zwischen dem Aluminiumgehäuseteil und dem Schubfeld verhindert werden.

Bei dieser Dichtung kann es sich beispielsweise um einen Dichtring handeln, der im Bereich des Gehäuseteils, insbesondere aber außerhalb des Gehäuses angeordnet ist. Bevorzugt weist die Baueinheit daher wenigstens ein an einer Außenoberfläche des Gehäuses angeordnete Dichteinrichtung und/oder Dämpfungseinrichtung auf, welche insbesondere in einem an ein Fahrzeug montierten Zustand der Baueinheit auf diese wirkende Vibrationen dämpft.

Bei einer weiteren vorteilhaften Ausführungsform sind die beiden Gehäuseteile bezüglich einander in der Längsrichtung und/oder der Breitenrichtung beweglich gelagert bzw. es ist ein gewisses Spiel zwischen den beiden Gehäuseteilen in wenigstens einer Bewegungsebene ermöglicht. Damit wird vorgeschlagen, dass diese Gehäuseteile insbesondere bezüglich einander in wenigstens einer Richtung und bevorzugt in zwei Richtungen beweglich, beispielsweise schwimmend gelagert sind.

Bevorzugt sind in dem Kunststoffteil, also einem Gehäuseteil, die Komponenten der Ferrite, die Spule und/oder die Platine bzw. der Schutzrahmen integriert. Diese sind wie erwähnt beweglich, beispielsweise schwimmend mit dem zweiten Gehäuseteil wie dem Aluminiumgehäuseteil verbunden. Aufgrund der stark unterschiedlichen Wärmeleitfähigkeiten der beiden Gehäuseteile kommt es zu stark unterschiedlichen Längenänderungen der beiden Materialien. Auch liegt beispielsweise die Wärmeleitfähigkeit eines Aluminiumgehäuseteils bei ca. 150 W/mK und die Wärmeleitfähigkeit des Kunststoffgehäuseteils bei ca. 0,7 W/mK. Bevorzugt erfolgt die Verbindung des Aluminiumgehäuseteils mit dem Kunststoffgehäuseteil mit Schrauben aus Metall und insbesondere Schrauben aus Aluminium. Derartige Schrauben haben den geringsten Einfluss auf die elektrische Funktion.

Bei einer weiteren vorteilhaften Ausführungsform können Platinen beispielsweise aus Epoxidharz hergestellt sein und ein Schutzrahmen (beispielsweise aus Polyesterharz) kann in dem Kunststoffgehäuseteil beispielsweise integriert und/oder befestigt werden. Auf diese Weise ergibt sich auch bei einem Temperaturschocktest keine Belastung für die Platine. Bei einem derartigen Temperaturschocktest kann das komplette Modul bzw. die Baueinheit innerhalb von fünf Sekunden von einem Raum mit + 105°C in einen Raum mit -40°C gebracht werden.

Bei einer weiteren vorteilhaften Ausführungsform sind die Befestigungsmittel zum Befestigen der Baueinheit an dem Fahrzeug an einem Gehäuseteil gelagert. In dem anderen Gehäuseteil, insbesondere dem Aluminiumgehäuseteil, sind Löcher vorgesehen. Diese Löcher sind bevorzugt derart ausgestaltet, dass die Befestigungsmittel ein gewisses Spiel innerhalb der Befestigungsmittel aufweisen.

Wie oben erwähnt weist die Baueinheit bevorzugt eine Kühleinrichtung zum Kühlen des wenigstens einen elektrischen Bauelements auf. Bevorzugt dient einer der beiden Gehäuseteile und insbesondere der metallische Gehäuseteil als (insbesondere passive) Kühleinrichtung. Es ist bevorzugt ein Wärmeleitmittel vorgesehen, insbesondere ein Wärmeleitpad. Bei einer weiteren vorteilhaften Ausführungsform ist an einem Gehäuseteil eine Vielzahl von Vorsprüngen angeordnet, welche in Ausnehmungen, welche an dem anderen Gehäuseteil angeordnet sind, eingreifen. So können beispielsweise Auflager im Inneren des Kunststoffgehäuseteils vorgesehen sein, welche für die entsprechenden Kunststoffteile der Isolierungen dienen, um so den auftretenden Belastungen insbesondere in der Z-Richtung der Baueinheit, das heißt im Fahrbetrieb in der vertikalen Richtung, Rechnung zu tragen.

Allgemein können auch Belastungen der Baugruppe bzw. der Baueinheit durch Kräfte, die über das sogenannte Schubfeld eingeleitet werden, erfolgen. Aufgrund der Werkstoffeigenschaften sollen diese Aufgaben hauptsächlich durch ein Aluminiumgehäuseteil übernommen werden. Durch die bewegliche bzw. schwimmende Verbindung zwischen den beiden Gehäuseteilen sollen Verformungskräfte auf insbesondere das Kunststoffgehäuseteil reduziert werden, damit es zu keiner Beschädigung der darin integrierten funktionellen Bauteile (Ferrite, Litze und Platine) kommt.

Bei einer bevorzugten Ausführungsform ist das elektrische Bauelement an einem der beiden Gehäuseteile befestigt und insbesondere an dem Kunststoffgehäuseteil.

Die vorliegende Erfindung ist weiterhin auf eine Vorrichtung zum induktiven Laden von Kraftfahrzeugen gerichtet, welche eine elektrische Baueinheit in der oben beschriebenen Art aufweist. Bevorzugt weist die induktive Ladeeinheit auch eine zweite Spuleneinrichtung auf, welche dazu geeignet und bestimmt ist, zur Übertragung von induktiver Energie mit der hier beschriebenen Baueinheit zusammenzuarbeiten.

Die vorliegende Erfindung ist weiterhin auf eine Vorrichtung zum induktiven Laden von Kraftfahrzeugen gerichtet. Diese Vorrichtung weist ein Gehäuse auf, sowie innerhalb dieses Gehäuses angeordnete elektrische Komponenten, wobei diese elektrischen Komponenten wenigstens eine Spuleneinrichtung, einen Ferritkörper und eine Bauteilplatine umfassen. Weiterhin weist die Vorrichtung wenigstens eine wenigstens teilweise außerhalb des Gehäuses angeordnete Schnittstelle auf, welche eine elektrisch leitende Verbindung bzw. Kontaktierung wenigstens einer der elektrischen Komponenten ermöglicht. Weiterhin handelt es sich bei dem Ferritkörper um einen plattenförmigen Körper.

Bevorzugt weist der plattenartige Körper eine Vielzahl von plattenartigen Ferritsegmenten auf, welche voneinander beabstandet sind. Auf diese Weise wird insgesamt auch bei dünnen Platten die Bruchfestigkeit erhöht. Vorteilhaft sind zwischen den einzelnen Ferritsegmenten Spalten ausgebildet. In diesen Spalten kann, wie unten genauer beschrieben, ein Material befindlich sein.

Bevorzugt weisen die Ferritsegmente jeweils eine Dicke auf, welche größer ist als 1 mm, bevorzugt größer als 2 mm, bevorzugt größer als 3 mm und besonders bevorzugt größer als 4 mm. Bevorzugt weisen die Ferritsegmente jeweils eine Dicke auf, die geringer ist als 20 mm, bevorzugt geringer als 15 mm, bevorzugt geringer als 10 mm, bevorzugt kleiner als 8 mm, besonders bevorzugt geringer als 6 mm und besonders bevorzugt geringer als 5 mm. Auch hier weist bevorzugt das Gehäuse einen ersten Gehäuseteil und einen zweiten Gehäuseteil auf sowie eine Dichtungseinrichtung, welche zwischen den beiden Gehäuseteilen wenigstens abschnittsweise vorhanden ist.

Die vorliegende Erfindung ist weiterhin auf eine Vorrichtung zum induktiven Laden von Kraftfahrzeugen gerichtet. Diese Vorrichtung weist ein Gehäuse auf sowie innerhalb dieses Gehäuses angeordnete elektrische Komponenten, wobei diese elektrischen Komponenten wenigstens eine Spuleneinrichtung, einen Ferritkörper und eine Bauteilplatine umfassen. Daneben weist die Vorrichtung wenigstens eine wenigstens teilweise außerhalb des Gehäuses angeordnete Schnittstelle auf, welche eine elektrisch leitende Kontaktierung zu wenigstens einer der elektrischen Komponenten ermöglicht. Weiterhin weist bevorzug der Ferritkörper eine plattenförmige Gestalt auf und/oder ist als plattenförmiger Körper ausgebildet. Weiterhin weist das Gehäuse eine erste Gehäusewandung auf sowie eine zweite Gehäusewandung, welche dieser ersten Gehäusewandung gegenüberliegt.

Bevorzugt ist die Bauteilplatine sowohl von der ersten Gehäusewandung als auch von der zweiten Gehäusewandung beabstandet und zwischen der Bauteilplatine und wenigstens einer der Gehäusewandungen ist ein wärmeleitendes Material angeordnet.

Bevorzugt weist das Gehäuse einen ersten Gehäuseteil und einen zweiten Gehäuseteil auf, welche besonders bevorzugt aneinander angeordnet sind. Bevorzugt ist die Spuleneinrichtung in einem der Gehäuseteile angeordnet und die Bauteilplatine in dem anderen Gehäuseteil. Bevorzugt ist der Ferritkörper in dem gleichen Gehäuseteil angeordnet, in dem auch die Spuleneinrichtung angeordnet ist.

Bei dieser Ausgestaltung wird vorgeschlagen, dass insbesondere ein wärmeleitendes Material die Bauteilplatine in thermisch leitender Weise mit wenigstens einer Gehäusewandung verbindet. Bevorzugt handelt es sich hier um eine metallische Gehäusewandung, beispielsweise aus Aluminium. Das wärmeleitende Material dient insbesondere zum Abführen von Wärme von der Bauteilplatine bzw. Elektronikplatine.

Die besagte Platine kann besonders bevorzugt eine Leistungselektronik aufweisen. Daneben kann die Platine auch Schaltkreise und dergleichen aufweisen. Bevorzugt weist die Vorrichtung auch eine Befestigungseinrichtung zum Befestigen an einem Kraftfahrzeug auf.

Bei einer weiteren vorteilhaften Ausführungsform sind die oben erwähnten Ferritsegmente wenigstens teilweise gegenüber einander beweglich. Auf diese Weise kann eine höhere Bruchsicherheit des gesamten Ferritkörpers erreicht werden. Dies ist insoweit vorteilhaft, als in Verbindung mit einem Kraftfahrzeug, in welchem die erfindungsgemäße Vorrichtung auch starken Vibrationen unterworfen ist, beispielsweise Vibrationen, welche bei dem Fahrbetrieb auftreten, aber auch erhöhte Vibrationen, welche beispielsweise durch unebene Straßen und dergleichen auftreten können.

Bevorzugt sind die einzelnen Ferritsegmente wenigstens teilweise jeweils gelenkig miteinander verbunden. Dies bedeutet, dass ein Ferritsegment bevorzugt gegenüber einem weiteren Ferritsegment um einen vorgegebenen Winkel schwenkbar ist und bevorzugt bezüglich einer Schwenkachse gegenüber diesem benachbarten Ferritsegment schwenkbar ist, welche durch einen zwischen den Segmenten bestehenden Spalt definiert wird. Bevorzugt wird diese Schwenkbarkeit durch ein zwischen den jeweiligen Ferritsegmenten angeordnetes Material ermöglicht. Dieses Material ist bevorzugt elastisch ausgebildet.

Daher ist der Ferritkörper derart ausgebildet, dass er solchen Stößen standhalten kann.

Bei einer weiteren vorteilhaften Ausführungsform ist zwischen den Ferritsegmenten wenigstens teilweise und/oder abschnittsweise ein Kunststoffmaterial angeordnet. Vorteilhaft kann es sich hierbei um Silikon handeln, beispielsweise um Silikonringe, welche um die einzelnen Ferritsegmente gelegt sind. Dabei können die Ferritsegmente an ihren Seitenabschnitten Nuten aufweisen, in welche ein Ferritring einlegbar ist.

Bei einer weiteren vorteilhaften Ausführungsform ist um wenigstens ein Ferritsegment voll umfänglich ein Kunststoffring angeordnet. Vorteilhaft entspricht dabei diese Ebene des Rings der Ebene des Segments.

Bei einer weiteren vorteilhaften Ausführungsform ist um den Ferritkörper herum ein Kunststoffmaterial angeordnet. Dabei kann es sich insbesondere um ebenfalls zur Abdichtung dienendes Material handeln.

Bei einer vorteilhaften Ausführungsform sind die einzelnen Ferritsegmente plattenartig aufgebaut. Dabei sind bevorzugt die Ferritsegmente jeweils gleichartig ausgebildet. Besonders bevorzugt handelt es sich um im Wesentlichen quadratische Platten, die besonders bevorzugt in einem Array angeordnet sind. So kann eine Vielzahl von Platten in einer ersten Richtung nebeneinander angeordnet sein und bevorzugt auch in einer zweiten Richtung, welche senkrecht zu der ersten Richtung steht.

Bei einer weiteren vorteilhaften Ausführungsform entsteht auf diese Weise insgesamt ein begrenzt flexibles Element, welches auch Stöße und Erschütterungen kompensieren kann, ohne dass einzelne oder mehrere Ferritelemente dabei brechen oder sonst beschädigt werden.

Bei einer weiteren vorteilhaften Ausführungsform ist eine von der Spuleneinrichtung gebildete Ebene und eine von dem Ferritkörper gebildete Ebene zueinander parallel. Bevorzugt dient der Ferritkörper zur Abschirmung und/oder zur Fokussierung eines Feldes.

Bei einer weiteren vorteilhaften Ausführungsform ist die Spuleneinrichtung an dem Ferritkörper angeordnet und besonders bevorzugt leicht von diesen beabstandet. Dabei ist es auch möglich, dass die Spuleneinrichtung mit einem Befestigungsmittel an dem Ferritkörper angeordnet ist, beispielsweise mit diesem vergossen ist. Bevorzugt dieses Befestigungsmaterial bzw. Befestigungsmittel isolierend ausgebildet.

Bevorzugt handelt es sich bei dem Befestigungsmittel und/oder Befestigungsmaterial um ein Kunststoffmaterial. Dieses ist bevorzugt elastisch, um bei etwa auftretenden Verformungen des Gehäuses durch Kräfte von außen die dabei entstehende Belastung und/oder Verformung der Ferritelemente vor Bruch oder Absplitterungen von kleinen Partikeln zu schützen.

Bevorzugt dient ein einziges Bauteil und insbesondere der genannte Gehäuseteil und insbesondere ein einziges Bauteil aus Kunststoff als Aufnahme für die Spuleneinrichtung und die Ferritelemente (evtl. gemeinsam mit deren Schutzelementen).

Dieses Bauteil aus Kunststoff erzeugt bevorzugt durch eine entsprechende konstruktive Gestaltung eine definierte Lage und/oder Aufnahme für die Spuleneinrichtung und/oder den Ferritkörper (ggfs. mit dessen Schutzelementen). Bevorzugt leitet dieses Bauteil und/oder gegebenenfalls ein weiteres Bauteil durch eine entsprechende konstruktive Gestaltung die in Z- Richtung wirkenden Kräfte an ein weiteres Bauteil und insbesondere den oben erwähnten weiteren Gehäuseteil, (welcher bevorzugt aus Metall besteht) weiter.

Bevorzugt ist die Spuleneinrichtung und insbesondere auch der Ferritkörper mit wenigstens einem und bevorzugt mehreren Lagerpunkten gegenüber dem Gehäuseteil aus Kunststoff gelagert. Besonders bevorzugt ist diese Lagerung derart gestaltet, dass sich die Spuleneinrichtung und/oder der Ferritkörper nicht in der oben erwähnten Z-Richtung bewegen können.

Bevorzugt weist die Vorrichtung einen Träger auf, der zum Halten sowohl der Spuleneinrichtung als auch des Ferritkörpers dient. Bevorzugt ist dieser Träger aus einem elektrisch isolierenden Material ausgebildet, insbesondere aus einem elektrisch isolierenden Kunststoff. Dabei kann dieser Träger auch zwischen der Spuleneinrichtung und dem Ferritkörper angeordnet sein, um so eine elektrische Isolierung zwischen diesen Bauteilen zu ermöglichen.

Bei einer weiteren vorteilhaften Ausführungsform sind daher die Spuleneinrichtungen der Ferritkörper wenigstens teilweise miteinander vergossen. Auch auf diese Weise kann die Stabilität der Anordnung erhöht werden. Besonders bevorzugt sind die Spuleneinrichtungen der Ferritkörper mit einem Epoxidharz miteinander vergossen.

Bei einer weiteren vorteilhaften Ausführungsform ist zwischen der Spuleneinrichtung und dem Ferritkörper wenigstens ein und bevorzugt eine Vielzahl von Lagerungspunkten und/oder Lagerungselementen vorgesehen. Bevorzugt ist dabei damit die Spuleneinrichtung gegenüber dem Ferritkörper gelagert und insbesondere in einer senkrecht zu einer Ebene der Spuleneinrichtung stehenden Richtung gelagert.

Bei einer weiteren vorteilhaften Ausführungsform kann es sich hier bei den Lagerungselementen jeweils um Punktlager handeln.

Bevorzugt sind die Spuleneinrichtungen und der Festkörper in einem ersten Bereich des Gehäuses angeordnet und die Bauteilplatine in einem hiervon beabstandeten zweiten Bereich. So kann das Gehäuse eine erste Kammer zur Aufnahme des Ferritkörpers und der Spuleneinrichtung ausbilden sowie eine zweite Kammer zur Aufnahme der Elektronikplatine bzw. Elektronikeinheit.

Bei einer weiteren bevorzugten Ausführungsform ist die Spuleneinrichtung und/oder der Ferritkörper seitlich an dem Gehäuse befestigt und/oder gehaltert.

Bei einer weiteren vorteilhaften Ausführungsform handelt es sich bei dem wärmeleitfähigen Material um eine wärmeleitende Paste, bevorzugt um eine flexible Paste. Diese flexible Paste kann dabei ebenfalls Stöße auf die Leiterplatine verhindern bzw. dämpfen. Damit kann die Paste sowohl als Temperaturleitmedium wirken als auch zur Stoß- bzw. Schockabsorbierung.

Bei einer weiteren vorteilhaften Ausführungsform ist diese wärmeleitfähige Paste auf mehreren Seiten der Elektronikplatine angeordnet und insbesondere auf wenigstens zwei gegenüberliegenden Seiten. Insbesondere ist, wie gesagt, die wärmeleitfähige Paste zwischen der Elektronikplatine und der Gehäusewandung angeordnet und besonders bevorzugt auch auf der jeweils gegenüberliegenden Wand der Elektronikplatine. Auf diese Weise ist eine besonders effiziente Abführung von Wärme von der elektronischen Leiterplatine möglich.

Bei einer weiteren vorteilhaften Ausführungsform ist die Paste eine Substanz, welche aus einer Gruppe von Substanzen ausgewählt ist, welche Silikon enthält. Weiterhin kann diese Paste auch thermoplastische Kunststoffe aufweisen. Daneben kann diese Substanz wärmeleitende Substanzen enthalten, insbesondere wärmeleitende Partikel. Dabei kann es sich beispielsweise um metallische Partikel handeln, etwa Kupfer-, Silber- oder Aluminiumpartikel.

Bei einer weiteren vorteilhaften Ausführungsform sind die Spuleneinrichtungen und der Ferritkörper innerhalb des Kunststoffgehäuseteils angeordnet. Dabei ist es möglich, dass insbesondere die Spuleneinrichtung vollständig innerhalb dieses Gehäuseteils einliegt, also insbesondere nicht in einer senkrecht zu ihrer Ebene stehenden Richtung über diesen Gehäuseteil hinausragt. Bevorzugt ist die Elektronikplatine in dem anderen Gehäuseteil bzw. im Bereich des zweiten Gehäuseteils angeordnet. Dabei werden jedoch bevorzugt die notwendigen Luft- und Kriechstrecken eingehalten.

Durch die hier beschriebene Vorgehensweise kann einerseits eine niedrige Bauhöhe der Vorrichtung erreicht werden, das heißt eine niedrige Bauhöhe bei Betrachtung in einer vertikalen bzw. Z-Richtung. Zur Erreichung dieser Anforderung wird besonders bevorzugt ein Teil der Spuleneinrichtung und insbesondere eine Litze der Spuleneinrichtung geschützt und/oder isoliert durch den Ferritkörper und/oder das Ferritfeld geführt.

Bei einer weiteren bevorzugten Ausführungsform sind im Inneren des Gehäuses Bereiche unterteilt, in denen sich einerseits die Litze bzw. die Spuleneinrichtung und der Ferritkörper befindet und im anderen Bereich, in dem die Platine angeordnet ist. Besonders bevorzugt weist die Vorrichtung einen Schutzrahmen auf, der die Elektronikplatine wenigstens teilweise umgibt. Bevorzugt ist an diesem Schutzrahmen und/oder der Elektronikplatine auch ein Anschlussfeld vorgesehen. Dieses Anschlussfeld erlaubt insbesondere eine elektrische Kontaktierung der Platine.

Erfindungsgemäß weist das Gehäuse eine Wandung auf, welche im Inneren des Gehäuses angeordnet ist und wenigstens teilweise einen ersten Bereich des Gehäuses von einem zweiten Teil des Gehäuses abtrennt. Dabei handelt es sich bei dem ersten Teil des Gehäuses um einen von dem ersten Gehäuseteil ausgebildeten Bereich des Gehäuses und bei dem zweiten Teil des Gehäuses um einen von dem zweiten Gehäuseteil ausgebildeten Bereich des Gehäuses. Diese beiden Bereiche des Gehäuses können dabei in z-Richtung übereinander liegen, sie können jedoch auch in einer horizontalen Richtung nebeneinander liegen.

Bevorzugt ist in dem besagten ersten Bereich des Gehäuses die oben erwähnte Elektronikplatine angeordnet und in dem zweiten Gehäuseteil die Spuleneinrichtung und der Ferritkörper.

Bevorzugt ist die besagte Wandung im Inneren des Gehäuses durchgehend ausgebildet und erstreckt sich insbesondere in der Längsrichtung des Gehäuses und der zu der Längsrichtung senkrecht stehenden Breitenrichtung. Bevorzugt dichtet diese Wandung die beiden Bereiche des Gehäuses voneinander fluiddicht und insbesondere flüssigkeitsdicht ab.

Bei einer ist diese Wandung als Deckel ausgebildet, der insbesondere den Ferritkörper bzw. dessen Ferritelemente abdeckt. Bevorzugt dient diese Wandung bzw. dieser Deckel auch als elektrische Isolierung zwischen dem Ferritkörper und dem aus Metall bestehenden Gehäuseteil. So kann sich diese Wandung auch in einen Übergangsabschnitt zwischen den beiden Gehäuseteilen erstrecken.

Bei einer bevorzugten Ausführungsform ist die Wandung aus einem Kunststoff hergestellt. Dabei kann auch diese Wandung zum Tragen und/oder Halten des Ferritkörpers dienen. So kann diese Wandung eine konstruktive Ausgestaltung aufweisen, die geeignet und bestimmt ist, eine definierte Aufnahme des Ferritkörpers zu ermöglichen.

Weiterhin kann diese Wandung derart ausgebildet sein, dass sie durch eine entsprechende konstruktive Gestaltung in z-Richtung wirkende Kräfte an denjenigen Gehäuseteil, der aus Metall besteht, weiterleitet. Bevorzugt ist die besagte Wandung aus einem Kunststoff gefertigt.

Es wird jedoch darauf hingewiesen, dass die besagte Wandung auch unabhängig von den oben genannten Ausgestaltungen Anwendung finden kann, also insbesondere auch unabhängig von der Ausführungsform nach der die Gehäuseteile aus unterschiedlichen Materialien gefertigt sind.

Bei einer weiteren bevorzugten Ausführungsform weist die Wandung jedoch Mittel und/oder wenigstens eine Öffnung zur Durchführung wenigstens einer elektrischen Leitung auf.

Bei einer weiteren bevorzugten Ausführungsform liegt die Wandung wenigstens abschnittweise an einem Abschnitt des zweiten Gehäuseteils auf. Bevorzugt liegt die Wandung an einzelnen definierten Lagerpunkten oder vollständig umlaufend an dem Abschnitt des zweiten Gehäuseteils auf. Bevorzugt ist die Wandung mit dem zweiten Gehäuseteil dichtend ausgebildet und besonders bevorzugt verklebt. Bevorzugt bildet die Wandung gemeinsam mit dem zweiten Gehäuseteil einen Aufnahmeraum zur Aufnahme der Spuleneinrichtung und des Ferritkörpers aus, wobei dieser Aufnahmeraum bevorzugt fluiddicht ist.

Bevorzugt ist eine derartige applizierte Dichtung oder Verklebung auf der Wandung bzw. dem Deckel aufgebracht und/oder auf dem zweiten Gehäuseteil (welches wie oben gesagt aus einem Kunststoff besteht).

Bei einer weiteren bevorzugten Ausführungsform ist in dem durch die Wandung ausgebildeten Raum innerhalb des zweiten Gehäuseteils wenigstens teilweise ein Vergussmaterial vorgesehen. Dieses Vergussmaterial kann dabei insbesondere in den vorgegebenen Zwischenräumen der Spuleneinrichtung, des Ferritkörpers und des zweiten Gehäuseteils vorgesehen sein. Mit anderen Worten kann durch eine entsprechende konstruktive Gestaltung des zweiten Gehäuseteils (aus Kunststoff) der Spuleneinrichtung und des Ferritkörpers, eines Trägers des Ferritkörpers und der Wandung ein Vergussmaterial in die vorgesehenen Zwischenräume (insbesondere bei allen Bauteilen in diesen fluiddichten Raum) gebracht werden.

Durch dieses Auffüllen der Zwischenräume mit einem Vergussmaterial kann eine sog. Kompaktierung aller in dem fluiddichten Raum befindlichen Komponenten erreicht werden. Diese Kompaktierung erhöht bevorzugt die Eigensteifigkeit und/oder Festigkeit des gesamten Gehäuses. Zu diesem Zweck kann es sich bei dem Vergussmaterial beispielsweise um Epoxidharz handeln.

Bei einer weiteren vorteilhaften Ausführungsform können zwischen einem Träger und insbesondere einem Kunststoffträger des Ferritkörpers Lagerpunkte vorgesehen sein, welche den Ferritkörper vor einer Schädigung durch in der z-Richtung auftretende Kräfte schützen.

Der oben genannte Schutzrahmen der Platine dient besonders bevorzugt zur Lagerung derselben. Auf diese Weise hat die Elektronikplatine einen definierten Abstand zu dem Gehäuseteil, beispielsweise dem Aluminiumgehäuseteil. Die Paste dient, wie oben erwähnt, auch zur Abführung von Wärme.

Auf diese Weise werden auch die elektronischen Bauteile auf der Platine, beispielsweise auch während Montagearbeiten, geschützt. Insbesondere können auf diese Weise die Kabelschuhe innerhalb eines Anschlussfeldes fixiert werden.

Daneben erlaubt dieser Schutzrahmen auch aufgrund seiner konstruktiven Ausführung den Schutz der Platine bzw. der elektronischen Bauteile auf der Platine. So wird insbesondere Schutz gegen Vibration ermöglicht.

Bei einer bevorzugten Ausführungsform wird auch auf beiden Seiten der Platine die dauerelastische und/oder Wärmeleitpaste verwendet. Somit kommt dieser Paste sowohl die Funktion der Wärmeabführung, also die Funktion der Vibrationsdämpfung als auch die Funktion einer Wärmespreizung zu.

Bei einer weiteren vorteilhaften Ausführungsform ist die Elektronikplatine und/oder die Spuleneinrichtung und/oder der Ferritkörper innerhalb eines Rahmenelements angeordnet. Dieses Rahmenelement kann wiederum in dem Gehäuseteil befestigt sein.

Die vorliegende Erfindung bezieht sich weiterhin auf eine induktive Ladeanordnung für Kraftfahrzeuge mit wenigstens einer Vorrichtung der oben beschriebenen Art.

Weitere Vorteile und Ausführungsformen ergeben sich aus den beigefügten Zeichnungen:

Darin zeigen:
- Fig. 1: Eine schematische Darstellung einer erfindungsgemäßen Vorrichtung;
- Fig. 2: eine perspektivische Darstellung einer erfindungsgemäßen Vorrichtung;
- Fig. 3: die Darstellung der Vorrichtung aus Figur 2 in einem teilweise geöffneten Zustand;
- Fig. 4: eine Detaildarstellung der Vorrichtung aus Fig. 3;
- Fig. 5: eine Darstellung der Vorrichtung zur Veranschaulichung der Montage in einem Kraftfahrzeug;
- Fig. 6: eine Detaildarstellung eines Ferritkörpers für eine erfindungsgemäße Vorrichtung;
- Fig. 7: eine Darstellung der erfindungsgemäßen Vorrichtung mit Anschluss;
- Fig. 8: eine Schnittdarstellung zur Veranschaulichung der Verbindung zwischen den Gehäuseteilen;
- Fig. 9: eine Schnittdarstellung zur Veranschaulichung der Anordnung der Befestigungseinrichtung;
- Fig. 10: eine Detaildarstellung zur Veranschaulichung der Konnektierung der Vorrichtung;
- Fig. 11: eine teilweise Schnittdarstellung der erfindungsgemäßen Vorrichtung;
- Fig. 12: eine Darstellung des zweiten Gehäuseteils;
- Fig. 13: eine weitere Schnittdarstellung der erfindungsgemäßen Vorrichtung; und
- Fig. 14: eine weitere Schnittdarstellung der erfindungsgemäßen Vorrichtung.

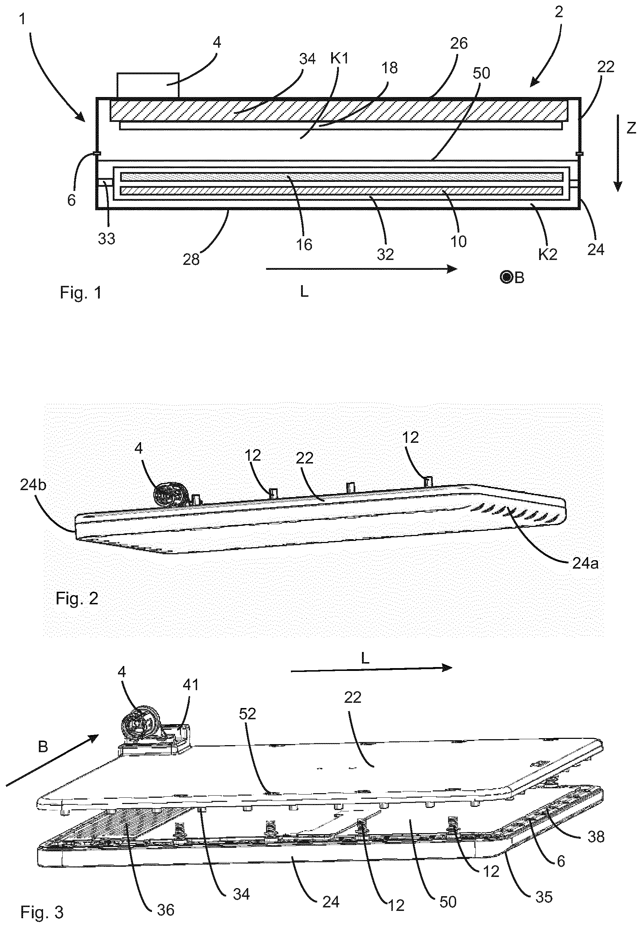

Figur 1 zeigt eine schematische Darstellung der erfindungsgemäßen elektrischen Baueinheit. Diese Baueinheit 1 weist ein Gehäuse 2 auf, wobei dieses Gehäuse 2 wiederum einen ersten Gehäuseteil 22 und einen zweiten Gehäuseteil 24 aufweist. Der Gehäuseteil 22 ist aus einem Metall gefertigt und der Gehäuseteil 24 aus einem Kunststoff. Das Bezugszeichen 50 Kennzeichnet eine Wandung, welche die beiden Gehäuseteile voneinander trennt und insbesondere gas- und/oder flüssigkeitsdicht voneinander trennt. Damit werden im Inneren des Gehäuses zwei Kammern K1 und K2 ausgebildet. Es bestehen jedoch (nicht gezeigte) elektrische Verbindungen zwischen diesen beiden Gehäuseteilen bzw. den elektronischen Elementen innerhalb des Gehäuses 2.

Das Bezugszeichen 18 kennzeichnet eine Elektronikplatine, welche in dem ersten Gehäuseteil angeordnet ist. Das Bezugszeichen 30 kennzeichnet ein temperaturleitendes und flexibles Element, welches eine Verbindung zwischen der Elektronikplatine 18 und der Wandung 26 des Gehäuseteils 22 herstellt. Das Bezugszeichen 4 kennzeichnet eine Anschlusseinrichtung, um die Vorrichtung elektrisch zu konnektieren.

Das Bezugszeichen 28 kennzeichnet eine zweite Wandung des Gehäuses, welche der Wandung 26 gegenüberliegt, wobei die hier beschriebenen elektrischen Komponenten zwischen diesen Wandungen 26 und 28 angeordnet sind. Das Bezugszeichen 10 kennzeichnet eine Spuleneinrichtung, welche innerhalb des Gehäuses und insbesondere innerhalb des zweiten Gehäuseteiles 24 angeordnet ist. Das Bezugszeichen 16 kennzeichnet einen unten genauer beschriebenen Ferritkörper, welcher ebenfalls innerhalb des zweiten Gehäuseteils und benachbart zu der Spuleneinrichtung 10 angeordnet ist.

Dabei ist es möglich, dass die Spuleneinrichtung 10 und der Ferritkörper 16 gemeinsam in ein Material 32 eingegossen sind. Das Bezugszeichen 33 kennzeichnet grob schematisch eine Halteeinrichtung zum Halten der Spuleneinrichtung 10 und des Ferritkörpers. Das Bezugszeichen Z kennzeichnet die Z-Richtung, bei der es sich in der Regel um eine vertikale Richtung handelt.

Das Bezugszeichen 6 kennzeichnet eine Dichtungseinrichtung, welche dazu geeignet und bestimmt ist, die beiden Gehäuseteile 22 und 24 bezüglich einander abzudichten. Dabei kann es sich, wie unten genauer beschrieben, auch um eine umlaufende Dichtung handeln. Bevorzugt ist auch die Platte, bzw. die Wandung 50 zwischen den beiden Gehäuseteilen 22. 24 angeordnet. Das Bezugszeichen L kennzeichnet eine Längsrichtung des Gehäuses 2. Eine Breitenrichtung B steht hier senkrecht zu der Figurenebene (vgl. Fig. 3).

Figur 2 zeigt eine Ansicht einer erfindungsgemäßen Vorrichtung 1. Man erkennt hier, dass der zweite Gehäuseteil 24 abgerundete Ecken 24b und auch abgerundete Kanten 24a aufweist. Auf diese Weise wird ein Windwiderstand verbessert. Das Bezugszeichen 12 kennzeichnet Befestigungsmittel, um die Vorrichtung 1 an ein Fahrzeug bzw. an einen entsprechenden Träger des Fahrzeugs anzuordnen. Auch erkennt man wieder die Schnittstelle 4, über welche die Vorrichtung 1 elektrisch mit dem Fahrzeug konnektiert werden kann.

Figur 3 zeigt die Vorrichtung aus Figur 2 in einem teilweise geöffneten Zustand. Dabei erkennt man wieder die Zwischenwand 50, welche den von dem ersten Gehäuseteil 22 gebildeten Innenraum und den von dem zweiten Gehäuseteil 24 gebildeten Innenraum flüssigkeitsdicht abtrennt.

Das Bezugszeichen 36 kennzeichnet einen Bestandteil einer Elektronikeinrichtung. Man erkennt, dass die Vorrichtung eine Vielzahl von Befestigungsmitteln 12 aufweist, die hier an dem zweiten Gehäuseteil 22 angeordnet sind und beispielsweise von unten her in diesen eingeschraubt und/oder eingeschoben werden können. Das Bezugszeichen 6 kennzeichnet eine umlaufende Abdichteinrichtung, die in einem zusammengebauten Zustand die beiden Gehäuseteile 22 und 24 gegeneinander abdichtet und so insbesondere auch das Eintreten von Flüssigkeiten in das Innere des Gehäuses verhindert. Das Bezugszeichen 38 kennzeichnet Auflager, welche mit Vorsprüngen 34, die hier an den ersten Gehäuseteil 22 angeordnet sind, zusammenwirken. Das Bezugszeichen 52 kennzeichnet Dichtungseinrichtungen, wie beispielsweise Dichtungsringe, welche zum Abdichten der Öffnungen dienen, durch welche die Befestigungseinrichtungen 12 geführt werden.

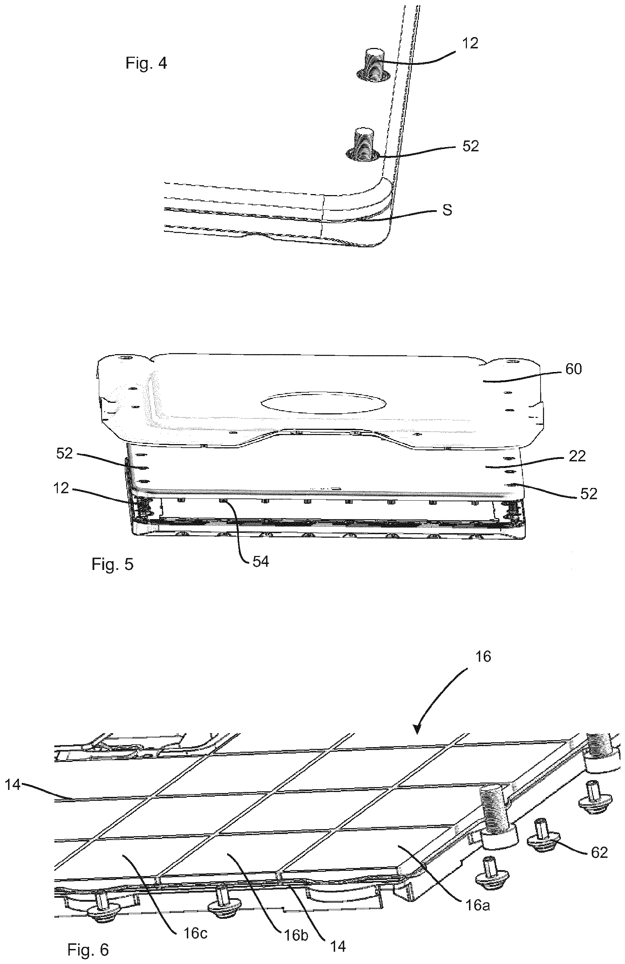

Figur 4 zeigt eine vergrößerte Darstellung eines Ausschnitts des Gehäuses. Dabei sind wieder die beiden Befestigungseinrichtungen 12 erkennbar sowie auch die Abdichteinrichtungen 52. Daneben erkennt man auch den Spalt S zwischen dem ersten Gehäuseteil 22 und dem zweiten Gehäuseteil 24. Dieser ist, wie oben erwähnt, ebenfalls abgedichtet.

Figur 5 veranschaulicht die Montage der erfindungsgemäßen Vorrichtung an einem Kraftfahrzeug bzw. einem Träger 60 des Kraftfahrzeugs. Man erkennt, dass hier der Gehäuseteil 22 zumindest abschnittsweise an diesem Träger 60 anliegt. Die einzelnen Dichtungen 52 sind ebenfalls erkennbar sowie auch die Schrauben 12, die anschließend durch diese Dichtungen geführt werden und mit dem Fahrzeugträger bzw. einer Befestigungseinrichtung verschraubt werden können.

Figur 6 zeigt den Ferritkörper 16, der vollständig innerhalb des zweiten Gehäuseteils 22 (hier nicht gezeigt) angeordnet ist. Dieser Ferritkörper 16 weist eine Vielzahl von Ferritsegmenten 16a, 16b, 16c auf, die hier quadratisch angeordnet sind. Zwischen diesen einzelnen Ferritsegmenten 16a, 16b, 16c sind Dichtungseinrichtungen vorgesehen, wobei diese Dichtungseinrichtungen die einzelnen Ferritsegmente insbesondere umfänglich umgeben können. Dabei ist es möglich, dass um jedes einzelne Ferritsegment 16a, 16b, 16c eine derartige Dichtung angelegt bzw. gezogen ist. Auf diese Weise sind die einzelnen Ferritsegmente 16a, 16b, 16c bezüglich einander in einem gewissen Maße beweglich und damit schwimmend gelagert.

Man erkennt weiterhin (Auf)lagerelemente 62, welche ebenfalls in dem unteren Gehäuseteil (nicht gezeigt) angeordnet werden. Diese Elemente erlauben insbesondere eine schwimmende Lagerung in Z-Richtung, das heißt in der Richtung, welche in Richtung der Straße weist, der beiden Gehäuseteile bezüglich einander. Diese Lagerelemente wirken insbesondere mit den Vorsprüngen 34 zusammen nun können abschnittsweise in diese hineinragen.

Dies wird untenstehend genauer erläutert. Daneben sind auch wieder die Befestigungseinrichtungen 12 gezeigt. Man erkennt, dass die Befestigungseinrichtungen 12 in einem zusammengebauten Zustand folglich weiter nach oben ragen als die Lagerelemente 62. Auch sind die Lagerelemente 62 innerhalb des zweiten Gehäuseteils tiefer angeordnet als die Befestigungseinrichtungen 12.

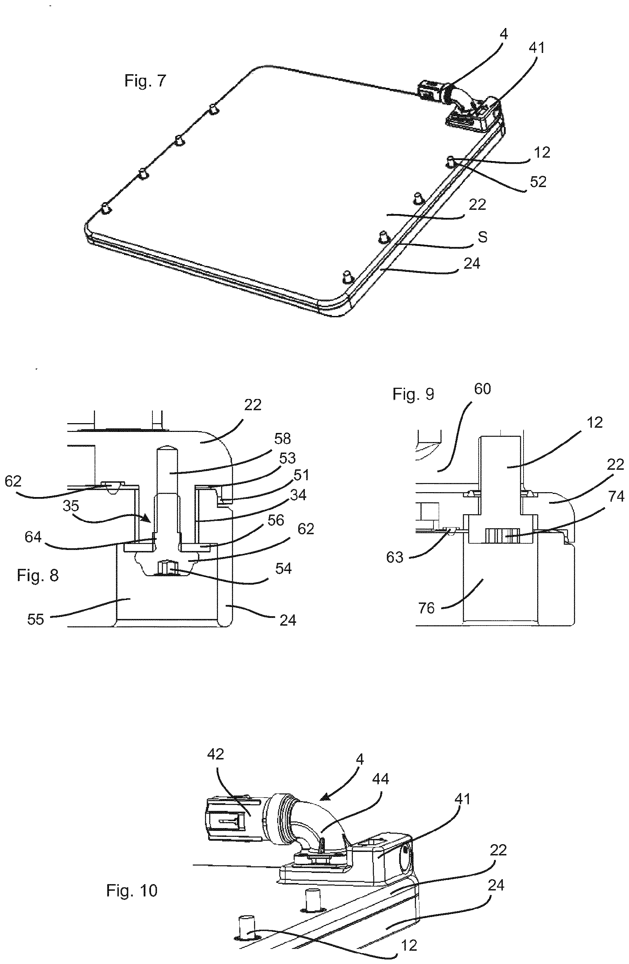

Figur 7 zeigt eine weitere Ansicht der erfindungsgemäßen Vorrichtung und auch hier wieder der beiden Gehäuseteile 22 und 24. Man sieht auch hier wieder den umlaufenden Spalt bzw. die Trennstelle zwischen den Gehäuseteilen. Daneben ist die Befestigungseinrichtung 12 erkennbar sowie auch der Halteschuh für die Schnittstelle 4.

Figur 8 zeigt eine Schnittdarstellung der erfindungsgemäßen Vorrichtung. Hier ist wieder der Gehäuseteil 22 und auch der Gehäuseteil 24 gezeigt. Man erkennt, dass diese beiden Gehäuseteile labyrinthartig miteinander verbunden sind. Man erkennt genauer, dass der Spalt S nicht unmittelbar in das Innere des Gehäuses führt, sondern in der Art eines Labyrinths zunächst erst nach oben und dann waagerecht nach links. Auf diese Weise kann eine sichere Flüssigkeitsabdichtung erreicht werden. Man erkennt weiterhin zwei Dichtungseinrichtungen 51, 53, welche die Zwischenräume zwischen den beiden Gehäuseteilen 22 und 24 abdichten. Auf diese Weise ist das Gehäuse mit zwei hintereinander angeordneten Dichtungseinrichtungen gesichert. Auf diese Weise kann nicht nur eine Abdichtung gegen gewöhnliches Spritzwasser aufrechterhalten werden, sondern auch eine Abdichtung beispielsweise im Falle einer Unterbodenwäsche für das Fahrzeug. Das Bezugszeichen 54 zeigt eine Ausnehmung in welche ein Werkzeug eingebracht werden kann.

Das Bezugszeichen 35 kennzeichnet wieder in ihrer Gesamtheit die Lagereinrichtung. Man erkennt, dass diese Lagereinrichtung 35 das Lagerelement 62 aufweist mit einer Schraubausnehmung 55, um beispielsweise ein Werkzeug einzusetzen. Das Bezugszeichen 56 kennzeichnet ein Dichtelement, wie etwa eine flexible Scheibe, welche eine gewisse Spannung bzw. auch eine Dämpfung des Lagers, insbesondere in der Z-Richtung erzeugt. Das Lagerelement 62 ruht voll umfänglich auf der Dämpfungsscheibe 56.

Das Bezugszeichen 58 kennzeichnet eine Ausnehmung bzw. Bohrung in dem Gehäuseteil 24, in welche das Lagerelement 62 eingeschraubt werden kann. Diese Ausnehmung ist wiederum innerhalb des Vorsprungs 34 angeordnet. Auf diese Weise stützt sich der Vorsprung 34 auch gegenüber dem zweiten Gehäuseteil 24 ab. Diese Dämpfungsscheibe ermöglicht damit eine schwimmende Lagerung der beiden Gehäuseteile 22, 24 gegenüber einander. Dabei ermöglicht diese Dämpfungsscheibe bevorzugt sowohl eine Spiel bzw. eine schwimmende Lagerung in Z-Richtung als auch in hierzu senkrechten Richtungen. So erkennt man, dass ein Außenumfang der Lagerelemente 62 kleiner ist als ein Innenumfang der Vorsprünge 34, so dass die Lagerelemente 62 auch gegenüber den Vorsprünge 34 in einer Ebene, welche senkrecht zu der Richtung Z steht bewegbar sind. Auf diese Weise wird auch in dieser Ebene eine schwimmende Lagerung der Gehäuseteile gegenüber einander erreicht.

Figur 9 zeigt eine Darstellung für die Befestigung der beiden Gehäuseteile an einem weiteren Element, beispielsweise einem Träger 60 eines Kraftfahrzeugs. Dabei ist das Befestigungsmittel 12 vorgesehen, welches in eine Ausnehmung 76 des zweiten Gehäuseteils 24 eingeführt und mit dem ersten Gehäuseteil verschraubt werden kann. Zu diesem Zweck weist das Befestigungsmittel 12 eine Ausnehmung 74 auf, in welche ein Werkzeug eingeführt werden kann. Das Bezugszeichen 63 kennzeichnet ein Dämpfungsmittel bzw. eine Dichtungseinrichtung, welche zwischen den beiden Gehäuseteilen 22 und 24 angeordnet ist. Dieses Dämpfungsmittel kann dabei auch ein Bestandteil der oben mit 6 bezeichneten Dichtungseinrichtung sein.

Figur 10 zeigt eine Veranschaulichung zur Anordnung der Schnittstelle 4. Diese Schnittstelle 4 weist dabei eine Kupplungseinrichtung 42 auf, welche mit einer (nicht gezeigten) weiteren Kupplungseinrichtung zusammenwirken kann. Das Bezugszeichen 44 kennzeichnet einen Kanal, der hier ausgehend von der Halteeinrichtung 41 um 90° gebogen ist, um auf diese Weise eine horizontale Ausrichtung der Kupplungseinrichtung 42 aufzuweisen. Daneben sind auch wieder die beiden Gehäuseteile 22 und 24 gezeigt sowie die Befestigungselemente 12. Es ist möglich, dass die Schnittstelle und/oder die Halteeinrichtung gegenüber dem ersten Gehäuseteil 22 drehbar ist, beispielsweise bezüglich der Z-Richtung um einen Winkel von 90° drehbar.

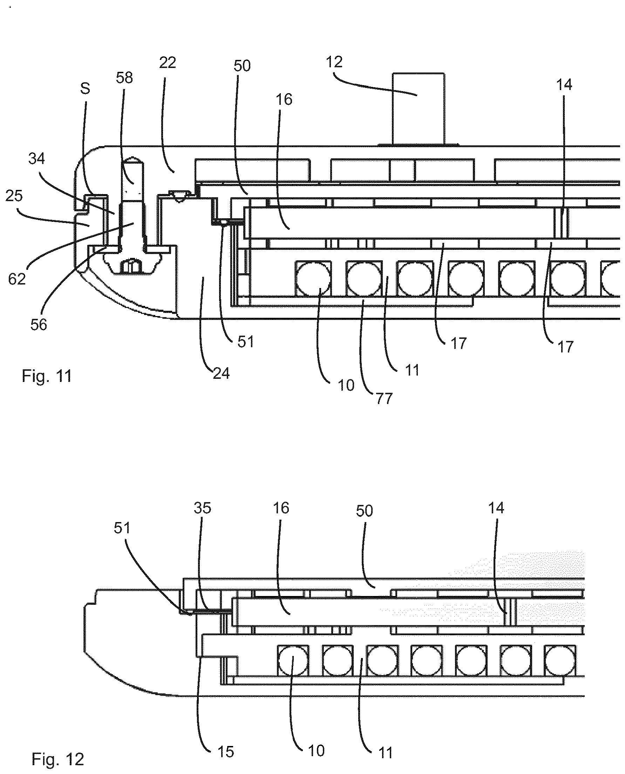

Figur 11 zeigt eine teilweise Schnittdarstellung einer erfindungsgemäßen Vorrichtung. Man erkennt hier wieder an der linken Seite den Übergang zwischen den Gehäuseteilen 22 und 24 und dass der Spalt zwischen den beiden Gehäuseteilen hier labyrinthartig ausgeführt ist, um das Eindringen von Flüssigkeiten in das Gehäuseinnere zu verhindern. Daneben erkennt man wieder das Lagerelement 62, welches in den ersten Gehäuseteil 22 eingeschraubt ist sowie auch das zugehörige Dichtelement 56, welches die Federung bzw. die gefederte Lagerung der beiden Lagerteile 22, 24 bezüglich einander in der Richtung Z ermöglicht. Innerhalb des zweiten Gehäuseteils 24 ist sowohl die Spuleneinrichtung 10 angeordnet als auch der Ferritkörper 16. Die Spuleneinrichtung 10 ist hier an einem Träger 11 angeordnet, wobei die einzelnen Windungen der Spule in entsprechenden Ausnehmungen des Trägers 11 einliegen. Der Träger 11 kann dabei aus einem Polyesterharz ausgebildet sein. Das Bezugszeichen 77 kennzeichnet einen Abstandshalter, der die Spuleneinrichtung und/oder den Träger von dem Gehäuseteil beabstandet.

Das Bezugszeichen 25 kennzeichnet ein an dem zweiten Gehäuseteil angeordnetes Abdichtmittel, welches insbesondere auch dazu dient, den labyrinthförmigen Spalt auszubilden. Das Bezugszeichen 65 kennzeichnet ein Dichtmittel, um die Gehäuseteile gegenüber einander abzudichten. Das Bezugszeichen 67 kennzeichnet ein weiteres Dichtmittel, um die Wandung 50 gegenüber dem unteren Gehäuseteil 24 abzudichten.

Der Ferritkörper 16 weist hier wiederum zwischen den einzelnen Ferritsegmenten die Spalte bzw. Kunststoffteile 14 auf. Zwischen der Spuleneinrichtung 10 und dem Ferritkörper 16 ist eine Vielzahl von Lagerelementen 17 vorgesehen, welche die Spuleneinrichtung 10 und den Ferritkörper 16, insbesondere in der Richtung Z, bezüglich einander lagern. Daneben können die Spuleneinrichtung 10 und der Ferritkörper 16 bezüglich einander in einen Kunststoff eingegossen sein.

Das Bezugszeichen 50 kennzeichnet wiederum die Abdeckplatte, welche die Komponenten, die in dem zweiten Gehäuseteil 24 angeordnet sind, abdeckt. Dabei kann diese Abdeckplatte auch gegenüber dem Gehäuseteil 24 mittels einer Abdichteinrichtung 51, die auch beispielsweise als umlaufender Ring ausgebildet sein kann, abgedichtet sein. Auf diese Weise wird der Bereich des Gehäuses, in dem die Spuleneinheit 10 und der Ferritkörper 16 angeordnet sind, abgetrennt von dem oberen Bereich des Gehäuses, in dem insbesondere auch die Elektronikplatine 18 angeordnet ist. Zwischen dem Ferritkörper 16 und der Abdeckwandung 50 können wiederum dämpfende Elemente vorgesehen sein, welche wiederum bei Vibrationen oder Stößen in Z-Richtung insbesondere auch den Ferritkörper 16 schützen.

Es ist auch hier wieder möglich, dass der Ferritkörper 16 schwimmend gelagert ist.

Figur 12 zeigt eine weitere Darstellung der erfindungsgemäßen Vorrichtung. Auch hier sind wieder die Spuleneinrichtung 10 und der Ferritkörper 16 zu sehen. Daneben ist auch hier wieder die Abdeckwand 50 gezeigt, welche zur Abdichtung des Gehäuseteils bzw. der darin angeordneten Elektronikkomponenten dient. Das Bezugszeichen 15 kennzeichnet eine Abstufung des zweiten Gehäuseteils, der gegenüber der Spuleneinrichtung 10 abgestützt ist. Auf diese Weise wird die Spuleneinrichtung 10 innerhalb des Gehäuseteils 24 gehaltert.

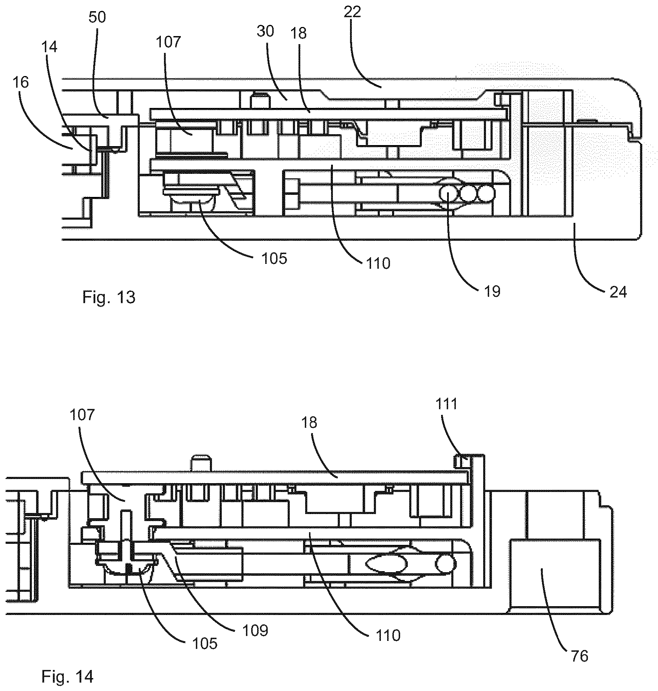

Figur 13 zeigt eine weitere Schnittdarstellung der erfindungsgemäßen Vorrichtung. Dabei bezieht sich das Bezugszeichen 22 wieder auf den ersten Gehäuseteil und das Bezugszeichen 24 auf den zweiten Gehäuseteil. Das Bezugszeichen 18 kennzeichnet die Elektronikplatine, die in dem ersten Gehäuseteil 22 gehaltert ist. In dem Bereich 30 ist eine elastische Wärmeleitpaste angeordnet, welche an der Elektronikplatine auftretende Wärme zu dem ersten Gehäuseteil 22 ableitet. Man erkennt, dass die Wandung 50 hier wiederrum den Raum, bzw. die Kammer in dem bzw. in der die Spuleneinrichtung und der Ferritkörper angeordnet sind von dem Raum bzw. der Kammer in dem bzw. in der die Elektronikplatine 18 angeordnet ist, abtrennt, wobei hier diese Räume auch seitlich nebeneinander sind.

Das Bezugszeichen 110 kennzeichnet einen Schutzrahmen bzw. Halterahmen, der insbesondere zum Halten der elektrischen Bauteile dient. An diesem Schutzrahmen 110 kann insbesondere auch die Spuleneinrichtung angeordnet sein. Das Bezugszeichen 19 kennzeichnet Litzen der Spuleneinrichtung. Das Bezugszeichen 107 kennzeichnet ein Bauteil, welches insbesondere auch zur Befestigung eines Kabelschuhs 109 dient. Diese Befestigung erfolgt dabei mittels eines Schraubmittels 105. Der Schutzrahmen kann dabei auch gegenüber der Bodenfläche des zweiten Gehäuseteils abgestützt sein.

Figur 14 zeigt wiederum eine weitere Schnittdarstellung der erfindungsgemäßen Vorrichtung, hier jedoch ohne den ersten Gehäuseteil 22. Erkennbar ist wiederum das Schraubmittel, welches zur Befestigung des Kabelschuhs dient. An dem Schutzrahmen 110 ist ein Vorsprung bzw. ein Positionierelement 111 angeordnet, der insbesondere auch zur Positionierung der Elektronikplatine 18 dient. Es wird weiterhin darauf hingewiesen, dass in den einzelnen Figuren auch Merkmale beschrieben wurden, welche für sich genommen vorteilhaft sein können. Der Fachmann erkennt unmittelbar, dass ein bestimmtes in einer Figur beschriebenes Merkmal auch ohne die Übernahme weiterer Merkmale aus dieser Figur vorteilhaft sein kann. Ferner erkennt der Fachmann, dass sich auch Vorteile durch eine Kombination mehrerer in einzelnen oder in unterschiedlichen Figuren gezeigter Merkmale ergeben können.

### Bezugszeichenliste

- 1: Vorrichtung
- 2: Gehäuse
- 4: Anschlusseinrichtung / Schnittstelle
- 6: Dichtungseinrichtung
- 10: Spuleneinrichtung
- 11: Träger
- 12: Befestigungsmittel
- 14: Kunststoffteile
- 15: Abstufung des zweiten Gehäuseteils
- 16: Ferritkörper
- 16a, 16b, 16c: Ferritsegmente
- 17: Lagerelemente
- 18: Elektronikplatine
- 19: Litzen
- 22: erster Gehäuseteil
- 24: zweiter Gehäuseteil
- 24a: abgerundete Kanten
- 24b: abgerundete Ecken
- 25: Abdichtmittel
- 26: Wandung
- 30: temperaturleitendes und flexibles Element
- 32: Material
- 34: Vorsprünge
- 35: Lagereinrichtung
- 36: Bestandteil eine Elektronikeinrichtung
- 38: Auflager
- 41: Halteeinrichtung
- 42: Kupplungseinrichtung / Verbindungseinrichtung
- 44: Kanal
- 50: Zwischenwand / Wandung / Abdeckplatte / Abdeckwandung
- 51, 53: Abdichteinrichtung
- 54: Ausnehmung für Werkzeug
- 52: Dichtungseinrichtungen
- 55: Schraubausnehmung
- 56: Dichtelement / Dämpfungsscheibe
- 58: Ausnehmung / Bohrung
- 60: Träger des Kraftfahrzeugs
- 62: Auflagerelemente / Lagerelemente
- 65, 67: Dichtmittel
- 72: Befestigungsmittel
- 74: Ausnehmung der Befestigungseinrichtung
- 76: Ausnehmung
- 77: Abstandshalter
- 105: Schraubmittel
- 107: Bauteil
- 109: Kabelschuh
- 110: Schutzrahmen
- 111: Positionierelement

- S: Spalt
- Z: Z-Richtung

## Patentansprüche

1. Elektrische Baueinheit (1) für Kraftfahrzeuge mit einem Gehäuse (2) innerhalb dessen wenigstens ein elektrisches Bauelement (10) angeordnet ist, mit einer Schnittstelle (4), welche eine elektrisch leitende Kontaktierung dieses Bauelements (10) ermöglicht, wobei das Gehäuse (2) einen ersten Gehäuseteil (22) und einen zweiten Gehäuseteil (24) aufweist, welche mit wenigstens einem Befestigungsmittel (12) aneinander befestigt sind und wobei sich die beiden Gehäuseteile jeweils zumindest entlang einer Längsrichtung (L) und einer zu dieser Längsrichtung (L) senkrechten Breitenrichtung (B) erstrecken, wobei der erste Gehäuseteil (22) und der zweite Gehäuseteil (24) aus unterschiedlichen Materialien gefertigt sind, wobei die elektrische Baueinheit zumindest eine Spule enthält, die zur Übertragung von elektrischer Energie auf induktivem Wege geeignet und bestimmt ist,
**dadurch gekennzeichnet, dass**
zwischen den beiden Gehäuseteilen (22, 24) ein umlaufender Spalt (S) ausgebildet ist
innerhalb dessen wenigstens ein Dichtmittel angeordnet ist, wobei sich dieser Spalt in Richtung des Inneren des Gehäuses labyrinthartig erstreckt und wenigstens zweimal seine Richtung wechselt und das Gehäuse eine Wandung (50) aufweist, welche im Inneren des Gehäuses angeordnet ist und wenigstens teilweise einen ersten Bereich des Gehäuses von einem zweiten Teil des Gehäuses abtrennt und die beiden Bereiche des Gehäuses voneinander fluiddicht abtrennt, wobei es sich bei dem ersten Teil des Gehäuses um einen von dem ersten Gehäuseteil ausgebildeten Bereich (K1) des Gehäuses und bei dem zweiten Teil des Gehäuses um einen von dem zweiten Gehäuseteil ausgebildeten Bereich (K2) des Gehäuses handelt

2. Elektrische Baueinheit (1) nach Anspruch 1,
**dadurch gekennzeichnet, dass**
ein Gehäuseteil (22, 24) aus einem Kunststoff gefertigt ist.

3. Elektrische Baueinheit (1) nach wenigstens einem der vorangegangenen Ansprüche, **dadurch gekennzeichnet, dass**
ein Gehäuseteil (24, 22) aus einem Metall gefertigt ist.

4. Elektrische Baueinheit (1) nach wenigstens einem der vorangegangenen Ansprüche, **dadurch gekennzeichnet, dass**
an wenigstens einem Gehäuseteil (22, 24) ein Befestigungsmittel (12) angeordnet ist, um die Elektrische Baueinheit (1) an dem Kraftfahrzeug zu befestigen.

5. Elektrische Baueinheit (1) nach wenigstens einem der vorangegangenen Ansprüche, **dadurch gekennzeichnet, dass**
die beiden Gehäuseteile (22, 24) bezüglich einander in der Längsrichtung (L) und/oder der Breitenrichtung (B) beweglich gelagert sind.

6. Elektrische Baueinheit (1) nach wenigstens einem der vorangegangenen Ansprüche, **dadurch gekennzeichnet, dass**
die Baueinheit (1) eine Kühleinrichtung zum Kühlen des wenigstens einen elektrischen Bauelements (10) aufweist.

7. Elektrische Baueinheit (1) nach wenigstens einem der vorangegangenen Ansprüche, **dadurch gekennzeichnet, dass**
an einem Gehäuseteil (24) eine Vielzahl von Vorsprüngen (72) angeordnet ist, welche in Ausnehmungen (34), welche an dem anderen Gehäuseteil angeordnet sind eingreifen.

8. Elektrische Baueinheit (1) nach wenigstens einem der vorangegangenen Ansprüche, **dadurch gekennzeichnet, dass**
das elektrische Bauelement (10) an nur einem der beiden Gehäuseteile (22, 24) befestigt ist.

## Claims

1. Electrical construction unit (1) for motor vehicles, having a housing (2) within which at least one electrical component (10) is arranged, having an interface (4) which enables electrically conductive contacting of this component (10), wherein the housing (2) having a first housing part (22) and a second housing part (24) which are fastened to one another by at least one fastening means (12) and wherein the two housing parts each extend at least along a longitudinal direction (L) and a width direction (B) perpendicular to this longitudinal direction (L), wherein the first housing part (22) and the second housing part (24) are made of different materials, wherein the electrical construction unit contains at least one coil which is suitable and intended for the transmission of electrical energy by inductive means,
**characterized in that**
a circumferential gap (S) is formed between the two housing parts (22, 24), within which gap at least one sealing means is arranged, wherein this gap extends in the direction of the interior of the housing in a labyrinth-like manner and changes its direction at least twice and the housing has a wall (50), which is arranged in the interior of the housing and at least partially separates a first region of the housing from a second part of the housing and separates the two regions of the housing from one another in a fluid-tight manner, wherein the first part of the housing being a region (K1) of the housing formed by the first housing part and the second part of the housing being a region (K2) of the housing formed by the second housing part.

2. Electrical construction unit (1) according to claim 1,
**characterized in that**
a housing part (22, 24) is made of a plastic material.

3. Electrical construction unit (1) according to at least one of the preceding claims,
**characterized in that**
a housing part (24, 22) is made of a metal.

4. Electrical construction unit (1) according to at least one of the preceding claims,
**characterized in that**
a fastening means (12) is arranged on at least one housing part (22, 24) in order to fasten the electrical construction unit (1) to the motor vehicle.

5. Electrical construction unit (1) according to at least one of the preceding claims,
**characterized in that**
the two housing parts (22, 24) are mounted so as to be movable relative to one another in the longitudinal direction (L) and/or the width direction (B).

6. Electrical construction unit (1) according to at least one of the preceding claims,
**characterized in that**
the construction unit (1) has a cooling device for cooling the at least one electrical component (10).

7. Electrical construction unit (1) according to at least one of the preceding claims,
**characterized in that**
a plurality of projections (72) are arranged on one housing part (24), which engage in recesses (34) arranged on the other housing part.

8. Electrical construction unit (1) according to at least one of the preceding claims,
**characterized in that**
the electrical component (10) is attached to only one of the two housing parts (22, 24).

## Revendications

1. Unité modulaire électrique (1) pour véhicules à moteur avec un boîtier (2), à l'intérieur duquel est disposé au moins un module électrique (10), avec une interface (4), laquelle permet une mise en contact électroconductrice dudit module (10), dans laquelle le boîtier (2) présente une première partie de boîtier (22) et une seconde partie de boîtier (24), lesquelles sont fixées l'une sur l'autre avec au moins un moyen de fixation (12) et dans laquelle les deux parties de boîtier s'étendent respectivement au moins le long d'une direction dans la longueur (L) et d'une direction dans la largeur (B) perpendiculaire à ladite direction dans la longueur (L), dans laquelle la première partie de boîtier (22) et la seconde partie de boîtier (24) sont produites à partir de différents matériaux, dans laquelle l'unité modulaire électrique contient au moins une bobine, qui est adaptée et se destine à la transmission d'énergie électrique par voie d'induction,
**caractérisée en ce que**
une fente (S) périphérique est réalisée entre les deux parties de boîtier (22, 24), à l'intérieur de laquelle au moins un moyen d'étanchéité est disposé, dans laquelle ladite fente s'étend en direction de l'intérieur du boîtier à la manière d'un labyrinthe et change au moins deux fois sa direction et le boîtier présente une paroi (50), laquelle est disposée à l'intérieur du boîtier et sépare au moins en partie une première zone du boîtier d'une seconde partie du boîtier et sépare les deux zones du boîtier l'une de l'autre de manière étanche aux fluides, dans laquelle la première partie de boîtier est une zone (K1) du boîtier réalisée par la première partie de boîtier et la seconde partie du boîtier est une zone (K2) du boîtier réalisée par la seconde partie de boîtier.

2. Unité modulaire électrique (1) selon la revendication 1,
**caractérisée en ce que**
une partie de boîtier (22, 24) est produite à partir d'une matière plastique.

3. Unité modulaire électrique (1) selon au moins l'une quelconque des revendications précédentes,
**caractérisée en ce que**
une partie de boîtier (24, 22) est produite à partir d'un métal.

4. Unité modulaire électrique (1) selon au moins l'une quelconque des revendications précédentes,
**caractérisée en ce que**
un moyen de fixation (12) est disposé sur au moins une partie de boîtier (22, 24) pour fixer l'unité modulaire électrique (1) sur le véhicule à moteur.

5. Unité modulaire électrique (1) selon au moins l'une quelconque des revendications précédentes,
**caractérisée en ce que**
les deux parties de boîtier (22, 24) sont montées de manière mobile l'une par rapport à l'autre dans le sens de la longueur (L) et/ou dans le sens de la largeur (B).

6. Unité modulaire électrique (1) selon au moins l'une quelconque des revendications précédentes,
**caractérisée en ce que**
l'unité modulaire (1) présente un système de refroidissement destiné à refroidir l'au moins un module électrique (10).

7. Unité modulaire électrique (1) selon au moins l'une quelconque des revendications précédentes,
**caractérisée en ce que**
une pluralité de parties faisant saillie (72), lesquelles viennent en prise avec des évidements (34), lesquels sont disposés sur une partie de boîtier, est disposée sur l'autre partie de boîtier (24).

8. Unité modulaire électrique (1) selon au moins l'une quelconque des revendications précédentes,
**caractérisée en ce que**
le module électrique (10) est fixé sur seulement une des parties de boîtier (22, 24).
